# EUROPÄISCHE PATENTSCHRIFT

(11) **EP 0 362 491 B1**
(45) Veröffentlichungstag und Bekanntmachung des Hinweises auf die Patenterteilung: **14.12.1994**
(21) Anmeldenummer: 89112533.8
(22) Anmeldetag: 08.07.1989
(51) Int. Cl.: H04L 12/26, H04L 1/20, G01R 25/00

(54) **Verfahren und Schaltungsanordnung zum Messen der Jittermodulation von nullenbehafteten Digitalsignalen**
Method and circuit arrangement for measuring jitter modulation in digital signals containing zeros
Méthode et circuit de mesure de la modulation de gigue dans des signaux numériques comportant des zéros

(30) Priorität: 01.10.1988 DE 3833486
(43) Veröffentlichungstag der Anmeldung: 11.04.1990
(73) Patentinhaber: WANDEL & GOLTERMANN GMBH & CO, D-72795 Eningen u.A. (DE)
(72) Erfinder: Brandt, Dieter, Dipl.-Ing., D-7412 Eningen u. A. (DE)
(74) Vertreter: Ott, Elmar, Dipl.-Ing.

(56) Entgegenhaltungen:
- EP-A- 0 011 699
- EP-A- 0 025 477
- EP-A- 0 166 839
- IBM TECHNICAL DISCLOSURE BULLETIN, Band 8, Nr. 5, Oktober 1965, Seite 819; G.J.SAXENMEYER: "Jitter distortion measuring circuit"

## Beschreibung

Die Erfindung betrifft ein Verfahren zum Messen der Jittermodulation von nullenbehafteten Digitalsignalen in dem die von bestimmten Impulsflanken des zu messenden jitterbehafteten Digitalsignals abgeleiteten Impulse mit einem jitterfreien Referenztaktpuls phasenverglichen werden sowie eine Schaltungsanordnung zur Durchführung des Verfahrens.

Aus der Technik der Phasenmodulation und -demodulation sind Phasenmesser bekannt, die auch in der Jittermeßtechnik für die digitale Übertragungstechnik verwendet werden. (Vgl. CCITT o. 171 und Definitionen).

Jittermessungen erfolgen hierbei im allgemeinen an binären Signalen, das heißt an Signalen mit im wesentlichen reckteckförmigem Verlauf über der Zeit.

Zur Rückgewinnung (Demodulation) der in der zeitlichen Position der Flanken eines Digitalsignales enthaltenen Phasenzeitfunktion phi(t) kommen grundsätzlich zwei Arten von Phasenvergleichern zur Anwendung:

Phasenvergleicher einer ersten Art setzen das die Phasenzeitfunktion phi(t) enthaltende Digitalsignal mit Hilfe von Bausteinen der digitalen Schaltungstechnik unter Zuhilfenahme eines jitterfreien Referenztaktsignales gleicher Bitfrequenz in ein pulsdauermoduliertes Signal um, aus dem die gesuchte Phasenzeitfunktion phi(t) durch Tiefpaßfilterung gewonnen wird. Solche Phasenmesser sind beispielsweise aus Tietze Schenk, Halbleiter-Schaltungstechnik/7. Auflage 1985, Springer Verlag, Abschnitt 26.4.3., Seiten 824 bis 827, bekannt.

Phasenvergleicher einer zweiten Art setzen den Phasenunterschied zwischen dem die Phasenzeitfunktion phi(t) enthaltendem Digitalsignal und einem jitterfreien Referenztaktsignal gleicher Bitfrequenz mit Hilfe eines Abtastphasenvergleichers in ein PAM-Signal um, das direkt die Phasenzeitfunktion darstellt. Dabei ist eine abschließende Tiefpaßfilterung nicht unbedingt erforderlich.

Phasenvergleicher dieser zweitgenannten Art arbeiten dabei im allgemeinen so, daß die Rampe eines die Referenzfrequenz aufweisenden Sägezahnsignals durch einen von dem zu messenden Digitalsignal abgeleiteten Impuls abgetastet wird. Die Folge der dabei erhaltenen Abtastwerte stellt die Phasenzeitfunktion phi(t) dar.

Ein Beispiel eines ähnlichen, allerdings mit einem sinusförmigen Referenzsignales arbeitenden Phasenvergleichers der zweitgenannten Art ist aus Tietze Schenk, Abschnitt 26.4.3., Seiten 819 bis 822 bekannt.

Phasenvergleicher der zweitgenannten Art besitzen zwar eine gute Linearität, doch ist ihr Aussteuerbereich gering. Er liegt real deutlicher unter ±(pi), bei höheren Bitfolgefrequenzen sogar noch unter ±(pi)/2. Werden größere Meßbereiche gefordert, so wären größere Rampenlängen notwendig, was aber ein "Verdünnen" der Flankendichte des Digitalsignales erfordern würde. Ein solcher Prozeß wäre aber für nullenbehaftete Digitalsignale nur schwer durchzuführen.

Phasenvergleicher der zweitgenannten Art bieten aber den großen Vorteil, daß sie für den unmittelbaren Betrieb an nullenbehafteten Digitalsignalen geeignet sind, da sie die detektierte Phase (bzw. einen äquivalenten Spannungswert) bis zum Eintreffen der nächsten Bitflanke speichern können, auch wenn diese Bitflanken nicht "äquidistant" vorliegen.

Sie bieten den weiteren großen Vorteil, daß sie den Spitzenwert unmittelbar am erzeugten PAM-Signal messen, wodurch eine theoretisch maximale Meßbandbreite realisiert werden kann.

Ein weiterer wichtiger Vorteil der Phasenvergleicher der zweitgenannten Art ist, daß bei der Spitzenwertmessung am PAM-Signal (ohne TP-Filterung) keine musterabhängigen zusätzlichen Meßfehler entstehen.

Der Erfindung liegt die Aufgabe zugrunde, ein Phasenvergleichsverfahren zum Zwecke der Messung der Jittermodulation und eine danach arbeitende Schaltungsanordnung anzugeben, das bzw. die
· direkt an beliebigen informationstragenden Digitalsignalen arbeitet,
· eine Umsetzung der Phase direkt in eine PAM-Spannung leistet
· eine grundsätzlich nicht beschränkte Aussteuerbarkeit besitzt.

Diese Aufgabe wird durch die Merkmale des Anspruchs 1 gelöst.

Die Erfindung besitzt die Vorteile,
· daß sie völlig musterunabhängig arbeitet,
· daß sie direkt am nullenbehafteten Digitalsignal arbeitet,
· daß sie Jittermessungen ohne Filterung ermöglicht und damit besonders fehlerarm arbeitet,
· daß dennoch jederzeit eine Filterung (nach CCITT) möglich ist,
· daß der Aussteuerbereich prinzipiell nicht beschränkt ist und
· daß sie relativ gut für viele verschiedene Bitfolgefrequenzen anwendbar ist.

Vorteilhafte Weiterbildungen der Erfindung sind in den Unteransprüchen gekennzeichnet.

Die Erfindung wird nachstehend anhand der Zeichnungen näher erläutert. Hierbei zeigt:
Figur 1 ein Blockschaltbild eines ersten Ausführungsbeispieles,
Figur 2 Pulsdiagramme mehrere in Figur 1 auftretender Signale,
Figur 3 ein vereinfachtes Zustandsdiagramm, das die Auswirkung festgestellter Unterschiede aufeinanderfolgender Speicherinhalte auf den Adressengenerator und den Startzeitpunkt des Rampengenerators beschreibt.
Figur 4 ein Blockschaltbild eines zweiten Ausführungsbeispiels,
Figur 5 ein Blockschaltbild eines dritten Ausführungsbeispiels.

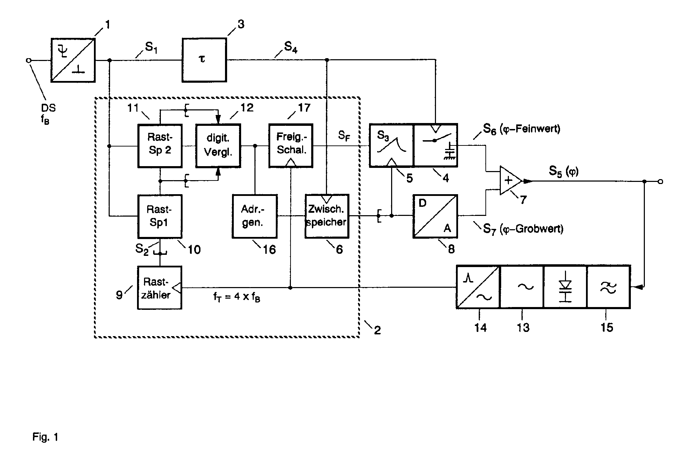

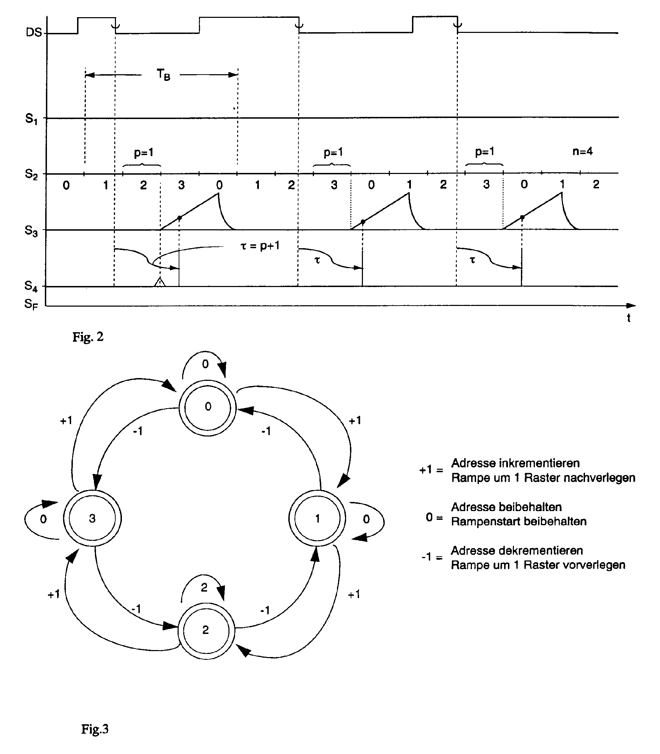

Bei der in Figur 1 dargestellten Anordnung, in der unter anderem die in Figur 2 dargestellten Signale auftreten, werden die fallenden Flanken eines Digitalsignals DS von einem Impulsformer 1 in Nadelimpulse S₁ umgewandelt, die an die Eingänge eines digitalen Grobwert-Phasenmessers 2 und eines Verzögerungsgliedes 3 gelangen. Das Ausgangssignal S₄ des Verzögerungsgliedes 3 liegt einerseits am Steuereingang eines einen Phasenfeinwert liefernden Abtastphasenvergleichers, der aus einer Abtast- und Halteschaltung 4 und einem diese speisenden Rampengenerator 5 besteht, und andererseits als Speicherübernahmesignal an einem Adressenspeicher 6 des Grobwert-Phasenmessers 2, dessen Ausgang am Eingang eines Digital/Analog-Wandlers 8 liegt.

Das einen Phasen-Feinwert darstellende Ausgangssignal S₆ der Abtast- und Halteschaltung 4 und das einen Phasen-Grobwert darstellende Ausgangssignal S₇ des Digital/Analog-Umsetzers 8 liegt jeweils an einem Eingang einer Summierschaltung 7, die sie zu einem Meßsignal S5 zusammenfaßt, das der gesuchten Jittermodulation proportional ist.

Der Phasen-Grobwertmesser 2 enthält einen Rastzähler 9, dessen Parallelausgänge mit den Paralleleingängen eines ersten Rastspeichers 10 verbunden sind. Dessen Parallelausgänge sind mit den Paralleleingängen eines zweiten Rastspeichers 11 verbunden. Beide Rastspeicher 10 und 11 empfangen vom Ausgang des Impulsformers 1 ein Speicherübernahmesignal. Die Ausgänge des ersten und des zweiten Rastspeichers 10 bzw. 11 liegen jeweils an einem Eingang eines Digitalvergleichers 12. Ein frequenzsteuerbarer Oszillator 13 liefert an einen Impulsformer 14 ein jitterfreies Signal mit der Frequenz f_{T}, die n = 4 mal höher ist als die Bittaktfrequenz f_{B} des Digitalsignales DS (f_{T} = 4f_{B}). Der Ausgang des Impulsformers 14 ist mit einem Fortschalteingang des Rastzählers 9 und mit einem Triggereingang des Rampengenerators 5 verbunden.

Das am Ausgang der Summierschaltung 7 liegende Meßsignal S₅ der Jittermessanordnung gelangt auch über einen Tiefpaß 15 an einen Steuereingang des Oszillators 13 und hält so die Phase von dessen Ausgangsfrequenz f_{T} jitterfrei auf einem mittleren konstanten Wert.

Im Grobwert-Phasenmesser 2 wird bei jedem Auftreten eines Nadelimpulses S1 der momentane Stand des Rastzählers 9 in den ersten Rastspeicher 10 und gleichzeitig dessen momentaner Speicherinhalt, der von der Lage des jeweils vorhergehenden Nadelimpulses abhängig ist, in den zweiten Rastspeicher 11 übernommen. Der Vergleicher 12 stellt den Unterschied zwischen dem momentanen und dem vorhergehenden Stand des Rastzählers 9 fest und gibt ihn einerseits an einen Adressengenerator 16 und andererseits an eine Freigabeschaltung 17 weiter. Letztere wird vom Impulsformer 14 mit einer dem n-fachen der Bittaktfrequenz f_{B} entsprechenden Frequenz 4f_{B} getaktet und bestimmt entsprechend Figur 3 aus der Teilperiode, während der der Nadelimpuls S₁ auftritt, die Teilperiode, zu deren Beginn der Rampengenerator 5 gestartet wird.

Der Adressengenerator 16 enthält unter den vom digitalen Vergleicher 12 gelieferten Adressen, die den Unterschieden der Phasenunterschiede zwischen dem Bittakt und aufeinanderfolgenden jitterbehafteten Nadelimpulsen S₁ entsprechen, die digitalen Phasengrobwerte der betreffenden Impulse des Digitalsignals DS, die er über den mit dem Ausgangssignal S4 des Verzögerungsgliedes 3 getakteten Zwischenspeicher 6 und den Digital/Analog-Umsetzer 8 als analoge Phasengrobwerte S₇ an die Summierschaltung 7 legt.

Besitzt das Digitalsignal DS keinen oder nur einen geringen Jitter, so wird beim Abtasten des Rastzählers 9 immer der gleiche Zählerstand vorgefunden, und es werden gemäß Figur 3 sowohl die Adresse als auch der Rampenstart nicht verändert. Das Ausgangssignal S₅ entspricht dann allein dem den Phasenfeinwert darstellenden Signal S₆ der Abtast- und Halteschaltung 4, weil der Vergleicher 12 in diesem Falle keinen Unterschied zwischen den Zählerständen feststellt und der Adressengenerator 16 den Phasengrobwert S₇ = Null liefert.

Bei Auftreten stärkeren Jitters wird der Vergleicher 12 auch positive oder negative Unterschiede vom Wert 1, 2 oder 3 feststellen, die nach ihrer Umsetzung im Adressengenerator 16 zu von Null verschiedenen digitalen Phasengrobwerten führen. Die daraus resultierenden Analogsignale S₇ werden von der Summierschaltung 7 zu den analogen Ausgangssignalen S₆ der Abtast- und Halteschaltung 4 addiert und als Ausgangssignale S₅ der Jittermeßanordnung ausgegeben. In diesem Falle wird auch der Rampenstart entsprechend Figur 3 um eine, zwei oder drei Teilperioden t nach- oder vorverlegt. Figur 3 stellt insoweit eine Vereinfachung dar, als sie nur die vom digitalen Vergleicher 12 festgestellten Unterschiede der Rastspeicherinhalte vom Wert 1 berücksichtigt.

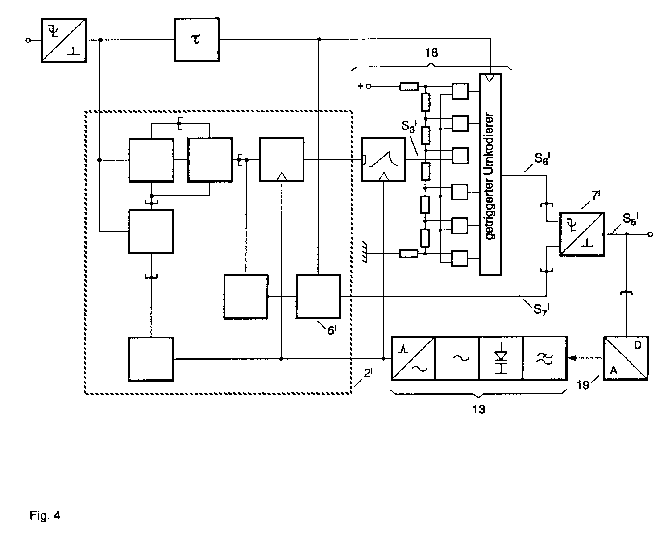

Das in Figur 4 dargestellte zweite Ausführungsbeispiel unterscheidet sich von der in Figur 1 dargestellten Anordnung im wesentlichen dadurch, daß zum Abtasten der Rampenspannung S₃′ an Stelle einer Abtast- und Halteschaltung (4, 5 in Figur 1) ein digitale Phasenfeinwerte liefernder Flash-A/D-Wandler (18) und ein digitaler Summierer 7′ vorgesehen sind, der das digitale Ausgangssignal S₆′ des Flash-A/D-Wandlers und das digitale Ausgangssignal S₇′des Zwischenspeichers 6′ des Grobwertmessers 2′ addiert und als digitales Meßsignal S₅′ abgibt. Ein D/A-Wandler 18 bildet aus dem Meßsignal S₅′ ein analoges Steuersignal für den Oszillator 13 .

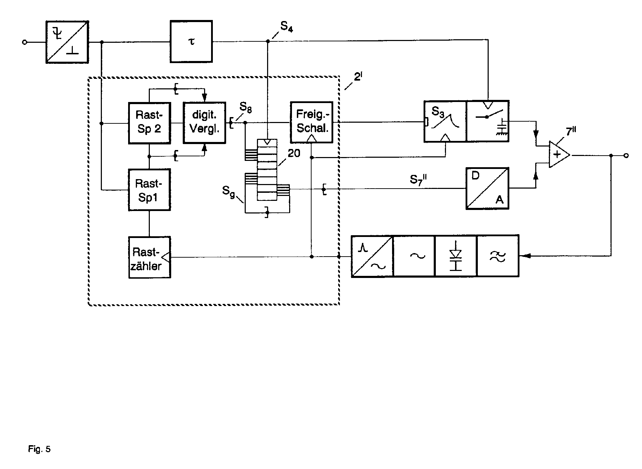

Das in Figur 5 dargestellte Ausführungsbeispiel unterscheidet sich von der in Figur 1 dargestellten Anordnung dadurch, daß an Stelle eines Adressengenerators und eines Zwischenspeichers (16 und 6 in Figur 1) ein als Addierschaltwerk geschalteter Lesespeicher 20 (ROM) angeordnet ist, in dem für alle Adressen und die zugehörigen neuen Rasterzustände jeweils die neuen (korrigierten) Adressen abgelegt sind. Mit Hilfe dieses Addierschaltwerks können außerdem Steuersignale aussteuerungsabhängig erzeugt werden.

## Patentansprüche

1. Verfahren zum Messen der Jittermodulation eines Digitalsignales, bei dem
erste Impulse, die von bestimmten Impulsflanken des zu messenden jitterbehafteten Digitalsignales (DS) abgeleitet sind, und zweite Impulse eines jitterfreien Referenztaktpulses, der aus dem die Bittaktfrequenz aufweisenden jitterbehafteten Digitalsignal abgeleitet ist, einem Phasenvergleich unterzogen werden,
die ersten Impulse ein linear ansteigendes Rampensignal (S₃) starten und die zweiten Impulse Abtastzeitpunkte des Rampensignals bestimmen,
die abgetasteten Werte des Rampensignals gehalten werden,
ein Wechselanteil des abgetasteten und gehaltenen Rampensignals der Jittermodulation proportional ist,
ein Gleichanteil des abgetasteten und gehaltenen Rampensignals eine Stellgröße für die Erzeugung der jitterfreien Referenzfrequenz bildet,
der Referenztaktpuls mit einer einem Vielfachen n der Bittaktfrequenz (f_{B}) entsprechenden Impulswiederholungsfrequenz nf_{B} = f_{T} erzeugt wird und die jede Bittaktperiode mit der Dauer T_{B} = l/f_{B} in n Teilperioden mit jeweils der Dauer t = T_{B}/n = l/nf_{B} unterteilt,
das Rampensignal bei Vorliegen eines Freigabesignals in jeder Bittaktperiode einmal gestartet wird,
das Rampensignal p Teilperioden nach dem Ende derjenigen Teilperiode, in der die bestimmte Impulsflanke des Digitalsignales (DS) auftritt, gestartet wird, wobei p = 0, 1, 2, ...< n ist,
die Rampenlänge des sägezahnförmigen Signales (S₃) 10 % bis 50 % länger als eine Teilperiode bemessen wird,
der Abtastimpuls (S₄) gegenüber der bestimmten Impulsflanke des Digitalsignals (DS) um p+1 Teilperioden verzögert wird,
ein Phasengrobwert (S₇) aus der Ordnungszahl derjenigen Teilperiode bestimmt wird, in der die bestimmte Impulsflanke des Digitalsignales auftritt und nach Ablauf von p Teilperioden ein Freigabesignal an den Rampengenerator (5) angelegt wird, und
ein Wechselanteil des abgetasteten und gehaltenen Rampensignals (S₆) und der Phasengrobwert (S₇) zu dem die Jittermodulation angebenden Meßwert (S₅) addiert werden.

2. Schaltungsanordnung zum Messen der Jittermodulation eines Digitalsignales, mit
einem Phasenvergleicher, durch den erste Impulse, die von bestimmten Impulsflanken des zu messenden jitterbehafteten Digitalsignales (DS) abgeleitet sind, und zweite Impulse eines jitterfreien Referenztaktpulses, der aus dem die Bittaktfrequenz aufweisenden jitterbehafteten Digitalsignal abgeleitet ist, einem Phasenvergleich unterzogen werden,
einem mit den ersten Impulsen triggerbaren und ein sägezahnförmiges Signal erzeugenden Rampengenerator (5) und mit einer mit dem Signal des Rampengenerators beaufschlagten und mit den zweiten Impulsen triggerbaren Abtast- und Halteschaltung (4),
einem Impulsformer (14) der den Referenztaktpuls erzeugt,
wobei der Referenztaktpuls mit einer einem Vielfachen n der Bittaktfrequenz (f_{B}) entsprechenden Impulswiederholungsfrequenz nf_{B} = f_{T} erzeugt wird und jede Bittaktperiode mit der Dauer T_{B} = l/f_{B} in n Teilperioden mit jeweils der Dauer t = T_{B}/n = l/nf_{B} unterteilt,
wobei ein Wechselanteil des abgetasteten und gehaltenen Rampensignals der Jittermodulation proportional ist,
und ein Gleichanteil des abgetasteten und gehaltenen Rampensignals eine Stellgröße für die Erzeugung der jitterfreien Referenzfrequenz bildet,
und ferner mit
einem Grobwertmesser (2), der in jeder Bittaktperiode diejenige Teilperiode bestimmt, in die die bestimmte Impulsflanke (S₁) des Digitalsignales (DS) fällt, der aus der Ordnungszahl dieser Teilperiode einen Phasengrobwert (S₇) bildet und der nach Ablauf dieser und p weiterer Teilperioden, mit p = 0, 1, 2, ... n-1 ein Freigabesignal (S_{F}) an den Rampengenerator (5) anlegt, wobei der Rampengenerator (5) nur einmal in jeder Bittaktperiode (T_{B}) zu Beginn einer Teilperiode (t) und nach Anlagen des Freigabesignals (S_{F}) gestartet werden kann, und
einen Summierer (7), der einen Wechselanteil des abgetasteten und gehaltenen Rampensignals (S₆) und den Phasengrobwert (S₇) zu dem die Jittermodulation angebenden Meßwert (S₅) addiert,
wobei die Rampenlänge des sägezahnförmigen Signales (S₃) 10 % bis 50 % länger als eine Teilperiode bemessen wird,
und wobei der Abtastimpuls (S₄) gegenüber der bestimmten Impulsflanke des Digitalsignals (DS) um p+1 Teilperioden verzögert wird.

3. Schaltungsanordnung nach Anspruch 2, **dadurch gekennzeichnet,** daß zur Erzeugung digitaler Phasenfeinwerte (S₆′) an Stelle einer Abtast- und Halteschaltung (4, 5 in Fig, 1) ein Flash-A/D-Wandler (18) vorgesehen ist.

4. Schaltungsanordnung nach Anspruch 2, **dadurch gekennzeichnet,** daß der Phasengrobwertmesser (2′) zur Erzeugung digitaler Phasengrobwerte (S₇˝) einen mit dem Abtastimpuls (S₄) getakteten Lesespeicher (20) (ROM) enthält, der als Addierschaltwerk geschaltet ist und der für jede gemessene Grobwertänderung (S8) und für jeden möglichen vorigen Grobwert (S₉) einen neuen digitalen Phasengrobwert (S₇˝) enthält, der über einen D/A-Wandler (21) einer Summierschaltung (7˝) zugeführt wird.

## Claims

1. Method of measuring the jitter modulation of a digital signal, wherein
first pulses, which are derived from specific pulse edges of the jitter-affected digital signal (DS) to be measured, and second pulses of a jitter-free reference timing pulse, which is derived from the jitter-affected digital signal having the bit timing frequency, are subjected to a phase comparison,
the first pulses start a linearly rising ramp signal (S₃), and the second pulses determine sampling times of the ramp signal,
the sampled values of the ramp signal are held,
an alternating portion of the sample and hold ramp signal is proportional to the jitter modulation,
a direct portion of the sample and hold ramp signal forms a standardising parameter for the generation of the jitter-free reference frequency,
the reference timing pulse is generated with a pulse repetition frequency nf_{B} = f_{T}, which corresponds to a multiple n of the bit timing frequency (f_{B}), and each bit timing period having the duration T_{B} = l/f_{B} is divided into n partial periods each having the duration t = T_{B}/n = l/nf_{B},
the ramp signal is started once a clear signal is present in each bit timing period,
the ramp signal is started p partial periods after the end of that partial period in which the specific pulse edge of the digital signal (DS) occurs, wherein p = 0, 1, 2, ..< n,
the ramp length of the saw-toothed signal (S₃) is dimensioned to be between 10 % and 50 % longer than one partial period,
the sampling pulse (S₄) is delayed relative to the specific pulse edge of the digital signal (DS) by p+1 partial periods,
an approximate phase value (S₇) is determined from the ordinal number of that partial period in which the specific pulse edge of the digital signal occurs, and a clear signal is applied to the ramp generator (5) after p partial periods have elapsed, and
an alternating portion of the sample and hold ramp signal (S₆) and the approximate phase value (S₇) are added to the measured value (S₅), which indicates the jitter modulation.

2. Circuit arrangement for measuring the jitter modulation of a digital signal, having
a phase comparator, by means of which first pulses, which are derived from specific pulse edges of the jitter-affected digital signal (DS) to be measured, and second pulses of a jitter-free reference timing pulse, which is derived from the jitter-affected digital signal having the bit timing frequency, are subjected to a phase comparison,
a ramp generator (5), which is triggerable with the first pulses and generates a saw-toothed signal, and a sample and hold circuit (4), which is actuated with the signal of the ramp generator and is triggerable with the second pulses,
a pulse shaper (14), which generates the reference timing pulse,
the reference timing pulse being generated with a pulse repetition frequency nf_{B} = f_{T}, which corresponds to a multiple n of the bit timing frequency (f_{B}), and each bit timing period having the duration T_{B} = l/f_{B} being divided into n partial periods each having the duration t = T_{B}/n = l/nf_{B},
an alternating portion of the sample and hold ramp signal being proportional to the jitter modulation,
and a direct portion of the sample and hold ramp signal forming a standardising parameter for the generation of the jitter-free reference frequency,
and also having
an approximate value measurer (2), which determines, in each bit timing period, that partial period into which the specific pulse edge (S₁) of the digital signal (DS) falls, and which measurer forms an approximate phase value (S₇) from the ordinal number of this partial period and applies a clear signal (S_{F}) to the ramp generator (5) after these and p additional partial periods have elapsed, with p = 0, 1, 2, ... n-1, the ramp generator (5) only being startable once in each bit timing period (T_{B}) at the beginning of a partial period (t) and after the clear signal (S_{F}) has been applied, and
a summation device (7), which adds an alternating portion of the sample and hold ramp signal (S₆) and the approximate phase value (S₇) to the measured value (S₅), which indicates the jitter modulation,
the ramp length of the saw-toothed signal (S₃) being dimensioned to be between 10 % and 50 % longer than one partial period,
and the sampling pulse (S₄) being delayed relative to the specific pulse edge of the digital signal (DS) by p+1 partial periods.

3. Circuit arrangement according to claim 2, characterised in that, to produce precise digital phase values (S₆′), a flash A-D converter (18) is provided instead of a sample and hold circuit (4, 5 in Fig. 1).

4. Circuit arrangement according to claim 2, characterised in that, to produce approximate digital phase values (S₇˝), the approximate value phase measurer (2′) includes a read only memory (ROM) (20), which is set by the sampling pulse (S₄) and is connected as an adding switching mechanism, said memory including, for each measured approximate value change (S₈) and for each possible spare approximate value (S₉), a new approximate digital phase value (S₇˝) which is fed to a summing circuit (7˝) via a D-A converter (21).

## Revendications

1. Procédé pour mesurer la modulation de gigue d'un signal numérique, selon lequel
- des premières impulsions qui sont dérivées de flancs d'impulsions définis du signal numérique (DS) à gigue à mesurer, et des secondes impulsions d'une impulsion de synchronisation de reférence sans gigue qui est dérivée du signal numérique à gigue présentant la fréquence de cycle binaire sont soumises à une comparaison de phases,
- les premières impulsions lancent un signal en rampe (S₃) augmentant linéairement et les secondes impulsions définissent des moments d'exploration du signal en rampe,
- les valeurs explorées du signal en rampe sont maintenues,
- une part variable du signal en rampe exploré et maintenu est proportionnelle à la modulation de gigue,
- une part constante du signal en rampe exploré et maintenu forme une grandeur de réglage pour la production de la fréquence de référence sans gigue,
- l'impulsion de synchronisation de référence est produite à une fréquence de récurrence d'impulsions nf_{B} = f_{T}, correspondant à un multiple n de la fréquence de cycle binaire (f_{B}), et chaque période de cycle binaire d'une durée T_{B} = l/f_{B} est divisée en n périodes partielles d'une durée t = T_{B}/n = l/nf_{B},
- le signal en rampe est lancé une fois en présence d'un signal de déclenchement dans chaque période de cycle binaire,
- le signal en rampe est lancé p périodes partielles après la fin de la période partielle dans laquelle l'impulsion de flanc définie du signal numérique (DS) apparaît, étant précisé que p = 0, 1, 2,... < n,
- la longueur de rampe du signal en dents de scie (S₃) est plus longue de 10% à 50% qu'une période partielle,
- l'impulsion d'exploration (S₄) est retardée de p+1 périodes partielles par rapport au flanc d'impulsion défini du signal numérique (DS),
- une valeur approximative de phase (S₇) est définie à partir du nombre ordinal de la période partielle dans laquelle apparaît le flanc d'impulsion défini du signal numérique, et après écoulement de p périodes partielles, un signal de déclenchement est appliqué au niveau du générateur de rampe (5), et
- une part variable du signal en rampe (S₆) exploré et maintenu et la valeur approximative de phase (S₇) sont additionnées pour former la valeur de mesure (S₅) indiquant la modulation de gigue.

2. Dispositif de couplage pour mesurer la modulation de gigue d'un signal numérique, comportant
- un comparateur de phases grâce auquel des premières impulsions qui sont dérivées de flancs d'impulsions définis du signal numérique (DS) à gigue à mesurer, et des secondes impulsions d'une impulsion de synchronisation de référence sans gigue qui est dérivée du signal numérique à gigue présentant la fréquence de cycle binaire sont soumises à une comparaison de phases,
- un générateur de rampe (5) apte à être déclenché à l'aide des premières impulsions et générant un signal en dents de scie, et un circuit d'exploration et de maintien (4) sollicité par le signal du générateur de rampe et apte à être déclenché à l'aide des secondes impulsions,
- un formateur d'impulsions (14) qui génère l'impulsion de cycle de référence,
étant précisé que l'impulsion de cycle de référence est générée à une fréquence de récurrence d'impulsions nf_{B} = f_{T} correspondant à un multiple n de la fréquence de cycle binaire (f_{B}), et chaque période de cycle binaire d'une durée T_{B} = l/f_{B} est divisée en n périodes partielles d'une durée t = T_{B}/n = l/nf_{B},
qu'une part variable du signal en rampe exploré et maintenu est proportionnelle à la modulation de gigue,
et qu'une part constante du signal en rampe exploré et maintenu forme une grandeur de réglage pour la production de la fréquence de référence sans gigue,
- et un organe de mesure de valeur approximative (2) qui définit dans chaque période de cycle binaire la période partielle dans laquelle rentre le flanc d'impulsion défini (S₁) du signal numérique (DS), qui forme, à partir du nombre ordinal de la période partielle, une valeur approximative de phase (S₇), et qui, après écoulement de cette période partielle et de p autres périodes partielles (p = 0, 1, 2,... n-1), applique un signal de déclenchement (S_{F}) au niveau du générateur de rampe (5), le générateur de rampe (5) pouvant être mis en marche une seule fois dans chaque période de cycle binaire (T_{B}), au début d'une période partielle (t) et après application du signal de déclenchement (S_{F}),
- ainsi qu'un organe de sommation (7) qui additionne une part variable du signal en rampe (S₆) exploré et maintenu et la valeur approximative de phase (S₇) pour former la valeur de mesure (S₅) indiquant la modulation de gigue,
étant précisé que la longueur de rampe du signal en dents de scie (S₃) est plus longue de 10% à 50% qu'une période partielle,
et que l'impulsion d'exploration (S₄) est retardée de p+1 périodes partielles par rapport au flanc d'impulsion défini du signal numérique (DS).

3. Dispositif de couplage selon la revendication 2, caractérisé en ce qu'il est prévu, pour générer des valeurs précises de phase numériques (S_{6′}), au lieu d'un circuit d'exploration et de maintien (4, 5 sur la figure 1), un convertisseur A/N parallèle (18).

4. Dispositif de couplage selon la revendication 2, caractérisé en ce que l'organe de mesure de valeurs approximatives de phase (2′) prévu pour générer des valeurs approximatives de phase numériques (S_{7˝}) contient une mémoire morte (20) (ROM), synchronisée avec l'impulsion d'exploration (S₄), qui est montée comme commutation à séquences d'addition et qui contient pour chaque variation de valeur approximative (S₈) mesurée et pour chaque valeur approximative précédente possible (S₉) une nouvelle valeur approximative de phase numérique (S_{7˝}) qui est transmise par l'intermédiaire d'un convertisseur N/A (21) à un circuit de sommation (7˝).
